# EUROPEAN PATENT SPECIFICATION

(11) **EP 1 669 424 B1**
(45) Date of publication and mention of the grant of the patent: **10.09.2008**
(21) Application number: 05111811.5
(22) Date of filing: 07.12.2005
(51) Int. Cl.: C09D 11/00

(54) **Ultraviolet ray curable inkjet ink**
Durch Ultraviolettstrahlung härtbare Tintenstrahltinte
Encre pour impression par jet d'encre durcissable par rayonnement ultraviolet

(30) Priority: 09.12.2004 JP 2004357297
(43) Date of publication of application: 14.06.2006
(73) Proprietor: SEIREN CO., LTD., Fukui-Shi Fukui (JP)
(72) Inventor: Itoh, Yoshikatsu, FUKUI-SHI, Fukui (JP); Nishikawa, Tomoyuki, FUKUI-SHI, Fukui (JP)
(74) Representative: Bongiovanni, Simone

(56) References cited:
- EP-A- 1 321 497
- US-A1- 2003 032 692
- US-A1- 2004 145 639
- US-A1- 2005 119 365

## Description

The present invention relates to an ultraviolet ray curable inkjet ink. Specifically, the present invention relates to an ultraviolet ray inkjet ink which can prevent an obtained cured coating from changing into yellow with heat.

In recent years, an inkjet printing employing an ultraviolet ray curable resin as the inkjet printing technology has been studied, other than aqueous or solvent inkjet printing. This ultraviolet ray curable resin has a merit of not requiring an ink receiving layer for a recording substrate since the resin has a feature of curing a resin instantly by being irradiated with the ultraviolet rays. Due to this merit, a use of the above ultraviolet ray curable resin is not only for coloring on paper, but also applications as a coloring agent to various materials such as films, plastics, metals and glass are also considered.

Also, since the ultraviolet curable resin is an excellent cured coating, its recorded material is capable of using both outside and inside of buildings. However, compared with an indoor use, an outdoor use is required to have excellent resistance properties dealing with any natural environmental conditions. Examples of the resistance properties are light resistance, heat resistance, water resistance and acid resistance. Also, a recorded material is required to keep its image for a certain period of time without change or degradation of colors.

Herein, regarding the ultraviolet ray curable inkjet printing, a method of recording an image on various materials has been reported since its colored cured coating is excellent in toughness such as light resistance and scratching resistance by examining appropriate coloring agents and resins.

However, under the present circumstances, behavior of the cured coating in terms of heat resistance is hardly studied. When a recorded material is used for various applications, depending on an inventory location for the recorded material, it is assumed that the recorded material is left for a long time at a temperature which is higher than an air temperature. For instance, a situation where the recorded material is left at an temperature of more than 80°C such as inside of a car subjected to direct sunlight is not rare. Under such an environment, when a recorded material printed by a ultraviolet ray curable inkjet printing is used, heat resistance becomes an very important physical property: thus, it can be predicted that a colored cured coating changes into yellow and images are degraded without considering heat resistance of an ink composition.

Against this problem, from the viewpoint that an aliphatic site is inactive to light and heat, as well as to chemicals, there is a case when an aliphatic reactive monomer is employed (for example, JP-A-7-330835). However, since many of aliphatic reactive monomers have small molecular weight, when employed for a flexible material such as films, its cured coating lacks flexibility and causes cracks at bending. Also, a material is limited in terms of adhesivity due to chemical inactivity, thus, it can not be considered a sufficient material.

Herein, it is considered that molecular weight of a reactive monomer employed in an ultraviolet ray curable ink is increased for a purpose of making a flexible cured coating and being capable of corresponding to flexible materials. Increase of molecular weight is achieved by adding an alkylene oxide group such as an ethylene oxide group or a propylene oxide group in a plurality of moles in a reactive monomer structure.

However, in this method, a ratio of an alkylene oxide group in the reactive monomer molecule becomes high, at the same time as increasing an active ether group in a molecule, a cured coating using those causes denaturation such as decomposition and oxidation with heat, thus has a problem in the point of heat resistance.

Other inkjet inks are disclosed in US 2003 032 692, US 2005 119 365 and EP 1 321 497.

An object of the present invention is to provide an ultraviolet ray curable inkjet ink in which a cured coating excellent in heat resistance, in addition to adhesivity and flexibility, is obtained.

Namely, the present invention relates to an ultraviolet ray curable inkjet ink according to claim 1.

Molecular weight of the above reactive monomer is preferably at least 300.

Molecular weight of the above reactive oligomer is preferably at least 1000.

According to the present invention, an ultraviolet ray curable inkjet ink in which a cured coating excellent in heat resistance in addition to adhesivity and flexibility is obtained is provided.

By selecting an aliphatic acrylate monomer having ester bonds except for acryloyl groups and/or one ether bond as a reactive monomer employed in the present invention, not only excellent in adhesivity and flexibility, but also inactive to heat, the present invention becomes possible to inhibit change of colors with heat.

The above aliphatic acrylate monomer can be represented by X-(A)n. X is a group comprising an aliphatic group, and preferably liner. A is an acryloyl group and has one ester bond. Namely, a reactive monomer used in the present invention has ester bonds except for acryloyl groups, which means that X group comprising the aliphatic group has an ester bond, and the monomer contains other ester bond other than the ester bond having an acryloyl group A.

Herein, when the aliphatic acrylate monomer has ester bonds except for acryloyl groups in its molecular structure, the number of the ester bonds is not particularly limited since an ester bond is inactive to heat. Also, when the aliphatic acrylate monomer has an ether bond in its molecular structure, increase of polarity can be suppressed and heat resistance is maintained by defining the number of ether bond as only one. Especially, an aliphatic acrylate monomer having an ester bond is preferable to obtain an ink excellent in particularly heat resistance.

The above reactive monomer is not particularly limited, if it is an aliphatic acrylate monomer having ester bonds except for acryloyl groups and/or one ether bond. Examples are
hexafunctional dipentaerythritol hexaacrylate, pentafunctional dipentaerythritol hydroxylpentaacrylate, tetrafunctional ditrimethylolpropane tetraacrylate, difunctional caprolactone adduct diacrylate of neopentyl glycol hydroxy pivalate ester, neopentyl glycol hydroxyl pivalate ester diacrylate, diethylene glycol diacrylate and dipropylene glycol diacrylate. These are used alone or in combination of at least two kinds.

Among those, from the viewpoint of being particularly excellent in flexibility, caprolactone adduct diacrylate of neopentyl glycol hydroxy pivalate ester and neopentyl glycol hydroxyl pivalate ester diacrylate, which are acrylate derived from neopentyl glycol, are preferable.

The number of a reactive functional group in a molecule of the reactive monomer is preferably 2 to 4. When the functional group is less than 2, it tends that the molecule can not form a continuous layer at curing, and when more than 4, although a hard cured coating can be obtained due to many crosslinking points, the cured coating tends to become inferior in adhesivity and scratching resistance since it is fragile. Further, it is preferable to be difunctional in viewpoints that the reactive monomer has relatively low viscosity and comparatively fast polymerization speed, and the obtained cured coating is relatively flexible.

When an ink of the present invention is used for flexible materials, molecular weight of the reactive monomer is preferably at least 300, and more preferably at least 400. Also, the molecular weight is preferably at most 800, and more preferably at most 600 in order to obtain sufficient dilution effects for lowering viscosity.

Examples of an ether bond in the above reactive monomer molecule structure are ether bonds derived from various types of alkylene oxide group such as ethylene oxide, propylene oxide, tetraethylene oxide and hexaethylene oxide. Among those, a relatively small molecular type such as an ethylene oxide and propylene oxide are preferable in a viewpoint of that increasing viscosity of a reactive monomer can be prevented.

As for ester bonds except for acryloyl groups in the reactive monomer molecule structure, a group constructing the ester bond is not particularly limited, but it is important not to contain a double bond and an aromatic ring in a view point of inhibition of lowering heat resistance and light resistance.

The reactive monomer is preferably contained in an amount of at least 80 % by weight in the ultraviolet ray curable ink of the present invention, and more preferably at least 85 % by weight. When less than 80 % by weight, effects of the present invention tends to be difficult to be obtained. Also, its upper limit is preferably 96.9 % by weight.

As a reactive oligomer employed in the present invention, an oligomer comprising an aliphatic acrylate excellent in heat resistance is employed. The oligomer is referred to be obtained by polymerization of 2 to 20 monomer units. Examples of aliphatic acrylates are aliphatic urethane acrylate, aliphatic epoxy acrylate and aliphatic polyester acrylate. Among those, aliphatic urethane acrylate is preferable in viewpoint of excellent in adhesivity for various materials, toughness and flexibility.

The reactive oligomer preferably has molecular weight of at least 1000 in viewpoints of being excellent in flexibility and adhesivity of a cured coating and curability of ink, and more preferably at least 1500. The upper limit is preferably 5000, and more preferably 3000. When an molecular weight is less than 1000, it tends to be difficult in performing toughness and flexibility an oligomer has. On the other hand, when molecular weight is more than 5000, an addition amount into ink can be limited and a prepared ink possibly shows the non-Newtonian viscosity feature; thus, it tends to lack inkjet discharging ability.

The reactive oligomer is preferably contained in an amount of at least 0.1 % by weight in the ultraviolet ray curable ink of the present invention, and more preferably at least 0.5 % by weight. The upper limit is preferably 10 % by weight, and more preferably 5 % by weight. When the reactive oligomer is from at least 0.1 % by weight to at most 10 % by weight, toughness, flexibility and adhesivity tend to be improved more.

As a photo-polymerization initiator employed in the present invention, examples are benzoins, thioxanthones, benzophenones, ketals and acetophenones. Among those, 1-hydroxy-cyclohexyl-phenyl-ketone of acetophenones is preferable in a viewpoint of being excellent in heat resistance.

The photo-polymerization initiator is preferably contained in an mount of at least 3 % by weight in the ultraviolet ray curable ink of the present invention. The upper limit is preferably 5 % by weight. When the amount is less than 3 % by weight, curing defect tends to occur since curing efficiency becomes poor, and when the amount is more than 5 % by weight, an unreacted amount which does not contribute to curing possibly increases, and degradation of resins tends to develop by generating radicals after ultraviolet ray irradiation.

Also, the ultraviolet ray curable inkjet ink of the present invention may contain a coloring agent, and can use both pigments and dye.

When weather resistance and light resistance are required for a recorded material, a pigment is preferably used, and an arbitrary one is selected regardless of whether it is organic or inorganic.

Examples of an organic pigment are nitroso compounds, dyeing lake compounds, azolake compounds, insoluble azo compounds, monoazo compounds, disazo compounds, condensated azo compounds, benzoimydazorone compounds, phthalocyanine compounds, anthraquinone compounds, perylene compounds, quinacridone compounds, dioxazine compounds, isoindorine compounds, azomethine compounds, and pyrrolo-pyrrole compounds.

Examples of an inorganic pigment are oxides, hydroxides, sulfides, ferrocyanides, chromates, carbonates, silicates, phosphates, carbons (carbon black) and metal powders.

On the other hand, when weather resistance and light resistance are not so important, dye can be utilized and an arbitrary one is selected without particular limitation.

Examples of dye are oil-soluble dye, nitro compounds and nitroso compounds, dispersion dye, acid dye, reactive dye, cationic dye, and direct dye such as azo compounds, anthraquinone compounds, indigoid compounds, phthalocyanine compounds, carbonium compounds, quinonimine compounds, methine compounds, xanthein compounds.

Other than those, additives such as a sensitizer for improving initiation reaction of a photo-polymerization initiator, a dispersing agent, heat-stabilizer, an antioxidant, an antiseptic, an antiforming agent and a penetrant can be added to the ultraviolet ray curable inkjet ink of the present invention, according to necessity.

To obtain the ultraviolet ray curable inkjet ink of the present invention, components which are used are mixed and the mixture is dispersed with a dispersing device such as a roll mill, a ball mill, a colloid mill, a jet mill or a beads mill, then filtration is conducted.

Considering corresponding to various materials, the surface tension of the ultraviolet ray curable inkjet ink is preferably 15 to 45 dyne/cm, and more preferably 30 to 45 dyne/cm. When the surface tension is less than 15 dyne/cm, images tend to bleed since wetting properties becomes too good, and when the surface tension is more than 45 dyne/cm, images tend to have many streaks since wetting properties becomes poor.

Also, an inkjet method using the ink of the present invention is not particularly limited. As the inkjet method, a continuous method such as a charge modulation method, a microdot method and an ink-mist method, and an on-demand method such as a piezo method, a bubble-jet method (registered trademark) and thermal inkjet method can be adopted.

Also, a heating device is mounted on the head which is equipped on an common inkjet printer to heat up an ink and the ink may be discharged by lowering viscosity with heat. An example of a heating temperature is in a range from 25 to 150°C, and preferably in a range from 30 to 70°C. A heating temperature is determined by considering curing properties for heat of a reactive oligomer which is employed, and the heating temperature is adjusted to be lower than a temperature when curing is initiated with heat. The ultraviolet ray curable ink of the present invention is excellent in heat resistance, and thus, change in hue does not occur even in case of being left under heating for a long period of time.

Viscosity of the ink at discharging an ink under heating is preferably 1 to 100 cps, and more preferably 5 to 50 cps. When viscosity is less than 1 cps, viscosity of the ink drop becomes too small, subsequently, a shape of the ink is not spherical but tends to disperse. When viscosity is more than 100 cps, continuous discharging tends to be impossible since an extreme load is required for the head at discharging.

As conditions for ultraviolet ray irradiation, a power of an ultraviolet ray lamp is preferably 50 to 280 W/cm, and more preferably 80 to 200 W/cm. When an power of an ultraviolet ray lamp is less than 50 W/cm, the ink does not tend to be cured sufficiently since a peak strength of the ultraviolet ray and an integrating amount of light are in short, and when a power of an ultraviolet ray lamp is more than 280 W/cm, a recording medium is modified or melted with heat of the ultraviolet ray lamp and a cured coating of the ink tends to decompose.

An ultraviolet ray irradiation time is preferably 0.1 to 20 seconds, and more preferably 0.5 to 10 seconds. When an irradiation time is more than 20 seconds, a recording medium is deformed or melted with heat of an ultraviolet ray lamp and a cured coating of the ultraviolet ray curable ink tends to decompose, and when a irradiation time is less than 0.1 second, an ink does not tend to be cured sufficiently since an integrating amount of light of the ultraviolet rays are in short.

Examples of a recording medium are a flexible material such as fibers, films, papers and metal foils; plastics; ceramics and; metals, but it is not limited thereto.

When printing by using the ultraviolet ray curing inkjet ink of the present invention, normally, these recording mediums are not treated, but it is possible to conduct a pre-treatment such as a primer treatment according to necessary.

The present invention is explained in detail with Examples in the following.

### EXAMPLES

### EXAMPLE 1

5 parts by weight of Ebecryl 8807 (aliphatic urethane acrylate, difunctional, molecular weight of 1500, available from DAICEL UCB Co,. Ltd.) as a reactive oligomer, 88.7 parts by weight of KAYARAD MANDA (neo pentyl glycol hydroxy pivalate ester diacrylate, the number of an ester group (other than an acryloyl group) of 1, difunctional, molecular weight of 312, available from Nippon KAYAKU CO,. LTD.) as a reactive monomer, 1 part by weight of HOSTAPERM PINK E-02 (quinacridone red, available from Clariant Japan K.K.) as a coloring agent, 0.3 part by weight of FLOWLEN DOPA -33 (available from KYOEISYA CHEMICAL Co., Ltd.) as a dispersing agent, and 5 parts by weight of IRGACURE184 (1-hydroxy-cyclohexyl-phenyl-ketone, available from Chiba Specialty Chemicals K.K.) as a photo-polymerization initiator were added and the mixture was dispersed by using a beads mill dispersing device, and then, impurities were removed by carrying out filtration to prepare a homogeneous magenta-colored ultraviolet ray curing inkjet ink.

The obtained ink was given to a recording medium Lumirror S 10 (a polyester film, 50 micron, available from Toray Industries. Inc.) by using an inkjet printer head and cured by an ultraviolet ray lamp.

Printing conditions and ultraviolet ray irradiation conditions are described in the following.

Viscosity of an ink at heating (60°C) was 10 cps and surface tension was 28 dyne/cm.

### [Printing conditions]

| | | |
|---|---|---|
| a) | Diameter of a nozzle : | 70 (µm) |
| b) | Impressed voltage : | 50 (V) |
| c) | Pulse width : | 20 (µs) |
| d) | Drive frequency : | 1 (kHz) |
| e) | Resolution : | 180 (dpi) |
| f) | Heating temperature : | 60 (°C) |

### [Ultraviolet ray irradiation conditions]

| | | |
|---|---|---|
| A) | Kind of a lump : | metal halide lamp |
| B) | Power of lamp : | 120 W/cm |
| C) | Irradiation time : | 1 sec. |
| D) | Irradiation distance : | 10 (mm) |

A film after printing an image and curing an ink by ultraviolet ray irradiation was left inside a dryer at 110°C for 400 hours and hue change of the film without leaving and after leaving was evaluated as follows. As a result, the film scarcely had a difference of hue change between without leaving and after leaving, and a film after being left also maintained a vivid magenta color. Further, the film resulted in excellent adhesivity and flexibility.

### [Evaluation test]

(1) Resistance against change into yellow: a temperature of 110°C, a leaving time for 400 hours
   No difference compared with a sample without being left: good
   Slight change into yellow compared with a sample without being left: not good
   Severe change into yellow compared with a sample without being left: bad
(2) Adhesivity: an adhesive cellophane tape was attached on a cured coating after the evaluation test (1) and peeled off swiftly, and a condition of the cured coating was evaluated.
   A cured coating is not peeled off from a substrate: good
   Cracks on a cured coating and air bubbles between a substrate and a cured coating appear: not good
   A cured coating is peeled off completely: bad
(3) Flexibility: A recording medium (film) in which an image was recorded after the evaluation test (1) was curled and a condition of the cured coating was evaluated.
   Cracks does not appear and a cured coating does not peel off from a substrate: good
   Cracks appear on a cured coating: not good
   A cured coating breaks and peels off from a substrate: bad

### EXAMPLE 2

A homogeneous magenta-colored ultraviolet ray curing inkjet ink was prepared in the same manner as Example 1, except for employing HX-220 (caprolactone adduct diacrylate of a neopentyl glycol hydroxy pivalate ester, the number of additional ester groups of 3, difunctional, molecular weight of 540, available from Nippon KAYAKU CO., LTD.) as a reactive monomer.

The obtained ink was given to a recording medium in the same manner as Example 1, and curing was conducted. Viscosity of the ink at heating (60°C) was 23 cps and surface tension was 30 dyne/cm.

As a result of conducting evaluations in the same manner as Example 1, the film scarcely had difference between without leaving and after leaving, and a vivid magenta color was maintained even on the film after being left. Further, the film resulted in excellent adhesivity and flexibility.

### EXAMPLE 3

A homogeneous magenta-colored ultraviolet ray curing inkjet ink was prepared in the same manner as Example 1, except for employing SR-230 (diethylene glycol diacrylate, the number of an additional ether group of 1, difunctional, molecular weight of 214, available from Sartomer Company, Inc.) as a reactive monomer.

The obtained ink was given to a recording medium in the same manner as Example 1, and curing was conducted.

Viscosity of the ink at heating (60°C) was 9 cps and surface tension was 30 dyne/cm.

As a result of conducting evaluations in the same manner as Example 1, the film scarcely had a difference between without leaving and after leaving, and a vivid magenta color was maintained even on the film after being left also. However, as for adhesivity, air bubbles appeared between a cured film and a substrate, and as for flexibility, the cured film had cracks.

### EXAMPLE 4

A homogeneous magenta-colored ultraviolet ray curing inkjet ink was prepared in the same manner as Example 1, except for employing 25 parts by weight of Ebecryl 5129 (aliphatic urethane acrylate, difunctional, molecular weight of 800, available from DAICEL UCB Co,. Ltd.) as a reactive oligomer, and 68.7 parts by weight of KAYARAD MANDA (neopentyl glycol hydroxy pivalate ester diacrylate, the number of an additional ester group of 1, difunctional, molecular weight of 312, available from Nippon KAYAKU CO., LTD.) as a reactive monomer.

The obtained ink was given to a recording medium in the same manner as Example 1, and curing was conducted.

Viscosity of an ink at heating (60°C) was 24 cps and surface tension was 29 dyne/cm.

As a result of conducting evaluations in the same manner as Example 1, the film scarcely had difference between without leaving and after leaving, and a vivid magenta color was maintained even on the film after being left also. However, as for adhesivity, air bubbles appeared between a cured film and a substrate, and as for flexibility, the cured film had cracks.

### COMPARATIVE EXAMPLE 1

A homogeneous magenta-colored ultraviolet ray curing inkjet ink was prepared in the same manner as Example 1, except for employing 5 parts by weight of Ebecryl 6700 (aromatic urethane acrylate, difunctional, molecular weight of 1500, available from DAICEL UCB Co,. Ltd.) as a reactive oligomer, and 88.7 parts by weight of Light Acrylate 3EG-A (triethylene glycol diacrylate, the number of additional ether groups of 2, difunctional, molecular weight of 286, available from KYOEISYA CHEMICAL Co., Ltd.) as a reactive monomer.

The obtained ink was given to a recording medium in the same manner as Example 1, and curing was conducted.

Viscosity of the ink at heating (60°C) was 10 cps and surface tension was 33 dyne/cm.

As a result of conducting evaluations in the same manner as Example 1, the film after being left severely changed into yellow and became orange. Further, as for adhesivity, air bubbles appeared between a cured film and a substrate, and as for flexibility, the cured film was broken and peeled off from the substrate.

**TABLE 1**

| | Ex.1 | Ex.2 | Ex.3 | Ex.4 | Com. Ex.1 |
|---|---|---|---|---|---|
| Resistance to change into yellow with heat | Good | Good | Good | Good | Bad |
| Adhesivity | Good | Good | Not good | Not good | Not good |
| Flexibility | Good | Good | Not good | Not good | Bad |

## Claims

1. An ultraviolet ray curable inkjet ink comprising a reactive monomer, a reactive oligomer, and a photo-polymerization initiator, wherein the reactive monomer is selected from the group consisting of difunctional caprolactone adduct diacrylate of neopentyl glycol hydroxy pivalate ester, neopentyl glycol hydroxyl pivalate ester diacrylate, diethylene glycol diacrylate, dipropylene glycol diacrylate and combinations thereof, and the reactive oligomer is an aliphatic acrylate oligomer.

2. The ultraviolet ray curable inkjet ink of Claim 1, wherein said reactive monomer has molecular weight of at least 300.

3. The ultraviolet ray curable inkjet ink of Claim 1, wherein said reactive oligomer has molecular weight of at least 1000.

## Patentansprüche

1. Durch ultraviolette Strahlung aushärtbare Tintenstrahltinte mit einem reaktiven Monomer, einem reaktiven Oligomer und einem Initiator einer Foto-Polymerisation, wobei das reaktive Monomer ausgewählt ist aus der Gruppe bestehend aus difunktionellem Caprolactondiacrylat-Addukt aus Neopentylglykolhydroxylpivalatester, Neopentylglykolhydroxylpivalatesterdiacrylat, Diethylenglykoldiacrylat, Diporpylenglykoldiacrylat und Kombinationen davon, und das reaktive Oligomer ein aliphatisches Acrylat-Oligomer ist.

2. Durch ultraviolette Strahlung aushärtbare Tintenstrahltinte nach Anspruch 1, in welcher das reaktive Monomer ein Molekulargewicht von wenigstens 300 hat.

3. Durch ultraviolette Strahlung aushärtbare Tintenstrahltinte nach Anspruch 1, in welcher das reaktive Oligomer ein Molekulargewicht von wenigstens 1000 hat.

## Revendications

1. Encre durcissable par rayonnement ultraviolet pour impression par jet d'encre, comprenant un monomère réactif, un oligomère réactif et un initiateur de photopolymérisation, dans laquelle le monomère réactif est choisi dans le groupe constitué par un produit d'addition bifonctionnel de caprolactone et de diacrylate d'ester hydroxy pivalate de néopentylglycol, un diacrylate d'ester hydroxyl pivalate de néopentylglycol, un diacrylate de diéthylèneglycol, un diacrylate de dipropylèneglycol et des combinaisons de ceux-ci, et l'oligomère réactif est un oligomère d'acrylate aliphatique.

2. Encre durcissable par rayonnement ultraviolet pour impression par jet d'encre selon la revendication 1, dans laquelle ledit monomère réactif a un poids moléculaire d'au moins 300.

3. Encre durcissable par rayonnement ultraviolet pour impression par jet d'encre selon la revendication 1, dans laquelle ledit oligomère réactif a un poids moléculaire d'au moins 1000.
